# EUROPEAN PATENT APPLICATION

(11) **EP 4 679 499 A1**
(43) Date of publication of application: **14.01.2026**
(21) Application number: 24766764.5
(22) Date of filing: 09.02.2024
(51) Int. Cl.: H01L 23/02, B81B 1/00, B81C 1/00

(54) **DEVICE AND DEVICE MANUFACTURING METHOD**

(30) Priority: 08.03.2023 JP 2023035148
(71) Applicant: Tazmo Co., Ltd., Okayama-shi, Okayama 701-1221 (JP)
(72) Inventor: IKAGAWA, Yoshinori, Okayama-shi, Okayama 701-1221 (JP)
(74) Representative: Knöner, Gregor
(86) International application number: PCT/JP2024/004449
(87) International publication number: WO 2024/185391

(57) **Abstract**

A method of manufacturing a device is a method of manufacturing a device including a cavity and comprises a joining step and an internal pressure adjusting step. In the joining step, two joining targets are joined to each other, thereby forming the cavity and sealing a gas adsorber in the cavity. The gas adsorber allows gas in the cavity to be adsorbed thereon by application of light. In the internal pressure adjusting step, an internal pressure in the cavity is adjusted by application of the light to the gas adsorber after the joining step.

## Description

### Technical Field

The present invention relates to a technique concerning a device including a cavity for sealing an element such as a sensor or an electronic circuit.

### Background Art

In many devices such as micro electro mechanical systems (MEMS), elements such as sensors (acceleration sensors, gyroscope sensors, etc.), micromachines (actuators, etc.), and electronic circuits are sealed in cavities (see Patent literature 1, for example). Such a device is provided by joining two joining targets (a joining target with a recess to become a cavity and a joining target to close the recess) to each other to form the cavity, and at the same time, sealing each element in the cavity.

Depending on the type of the element to be sealed in the cavity, it is important, in some cases, that an internal pressure in the cavity be at an appropriate value in terms of enhancing the performance of the element. As an example, if the element is an acceleration sensor, the internal pressure in the cavity is preferably at a moderately low value in order to allow the acceleration sensor to be damped by air resistance. As another example, if the element is a gyroscope sensor, the internal pressure in the cavity is preferably as low as possible (in other words, a degree of vacuum is preferably as high as possible).

According to a method conventionally employed for adjusting the internal pressure in the cavity to an appropriate value, an adjustment is made to make an internal pressure in a chamber equal to an intended internal pressure in the cavity and then the above-described two joining targets are joined to each other in the chamber.

### Citation List

### Patent Literature

Patent literature 1: Japanese published unexamined patent No. 2013-251743

### Summary of Invention

### Technical Problem

However, the above-described conventional method has a problem as follows. If the internal pressure in the cavity is intended to be reduced as much as possible, the internal pressure in the chamber is required to be adjusted as low as possible and such an adjustment takes a long time. Furthermore, if heating the two joining targets is required during joining between the joining targets, even each element in the cavity is heated by the heating and this causes a risk of generating gas from the element. The generation of gas from each element makes it difficult to reduce the internal pressure in the cavity to an intended value due to the gas. As described above, it is difficult to control the internal pressure in the cavity efficiently with high accuracy by the conventional method.

Thus, the present invention is intended to provide a technique concerning a device including a cavity and allowing an internal pressure in the cavity to be controlled efficiently with high accuracy.

### Solution to Problem

A first aspect of a method of manufacturing a device according to the present invention is a method of manufacturing a device including a cavity and comprises a joining step and an internal pressure adjusting step. In the joining step, two joining targets are joined to each other, thereby forming the cavity and sealing a gas adsorber in the cavity. The gas adsorber allows gas in the cavity to be adsorbed thereon by application of light. In the internal pressure adjusting step, an internal pressure in the cavity is adjusted by application of the light to the gas adsorber after the joining step.

According to the first aspect of the manufacturing method described above, by setting the gas adsorber as an application target for the light (more specifically, a target for heating by application of the light), it becomes possible for gas in the cavity to be adsorbed on the gas adsorber to reduce the internal pressure in the cavity without heating an element (such as a sensor) sealed in the cavity. In other words, even if the element (such as a sensor) sealed in the cavity is an element to influence the internal pressure in the cavity (in terms of generation or adsorption of gas, for example) by being heated, the first aspect of the manufacturing method described above can still prevent heating of the element (such as a sensor) sealed in the cavity, thereby allowing the internal pressure in the cavity to be reduced using only the gas adsorber without causing an influence from the element. Thus, it is possible to reduce the internal pressure in the cavity efficiently in a short time. Furthermore, by adjusting a condition for applying the light to the gas adsorber, it becomes possible to control the internal pressure in the cavity with high accuracy.

In the first aspect of the manufacturing method described above, in the joining step, a gas generator may further be sealed in the cavity in addition to the gas adsorber. The gas generator allows gas to be generated into the cavity by application of the light. In this case, in the internal pressure adjusting step, the internal pressure in the cavity may be adjusted by application of the light to at least one of the gas adsorber and the gas generator. In this configuration, by setting the gas adsorber and the gas generator as application targets for the light (more specifically, targets for heating by application of the light) and applying the light selectively to the application targets, it becomes possible for gas in the cavity to be adsorbed on the gas adsorber to reduce the internal pressure in the cavity and also possible to generate gas from the gas generator into the cavity to increase the internal pressure in the cavity without heating the element (such as a sensor) sealed in the cavity. In other words, it is possible to adjust the internal pressure in the cavity by using the gas adsorber and the gas generator selectively without causing an influence from the element (such as a sensor) sealed in the cavity. This allows the internal pressure in the cavity to be adjusted efficiently in a short time. Furthermore, by adjusting a condition for applying the light to the gas adsorber and the gas generator, it becomes possible to control the internal pressure in the cavity with high accuracy.

A second aspect of a method of manufacturing a device according to the present invention is a method of manufacturing a device including a cavity and comprises a joining step and an internal pressure adjusting step. In the joining step, two joining targets are joined to each other, thereby forming the cavity and sealing a gas generator in the cavity. The gas generator allows gas to be generated into the cavity by application of light. In the internal pressure adjusting step, an internal pressure in the cavity is adjusted by application of the light to the gas generator after the joining step.

According to the second aspect of the manufacturing method described above, by setting the gas generator as an application target for the light (more specifically, a target for heating by application of the light), it becomes possible to generate gas from the gas generator into the cavity to increase the internal pressure in the cavity without heating an element (such as a sensor) sealed in the cavity. In other words, even if the element (such as a sensor) sealed in the cavity is an element to influence the internal pressure in the cavity by being heated, the second aspect of the manufacturing method described above can still prevent heating of the element (such as a sensor) sealed in the cavity, thereby allowing the internal pressure in the cavity to be increased using only the gas generator without causing an influence from the element. Thus, it is possible to increase the internal pressure in the cavity efficiently in a short time. Furthermore, by adjusting a condition for applying the light to the gas generator, it becomes possible to control the internal pressure in the cavity with high accuracy.

In the first aspect or the second aspect of the manufacturing method described above, in the internal pressure adjusting step, the internal pressure in the cavity may be measured, and on the basis of a measured value about the internal pressure, the light may be applied in such a manner that the internal pressure falls within a predetermined range. In this configuration, if the element such as a sensor is sealed in the cavity, it is possible to adjust the internal pressure in the cavity with high accuracy to a value suitable for the element.

A third aspect of a method of manufacturing a device according to the present invention is a method of manufacturing a plurality of devices each including a cavity and comprises a joining step and an internal pressure adjusting step. In the joining step, two joining targets are joined to each other, thereby forming a plurality of the cavities and sealing an internal pressure adjusting member in each of the cavities. The internal pressure adjusting member allows an internal pressure in the cavity to be adjusted by application of light. In this case, the internal pressure adjusting member to be sealed in units of the cavity is at least one of a gas adsorber that allows gas in the cavity to be adsorbed thereon by application of the light and a gas generator that allows gas to be generated into the cavity by application of the light. In the internal pressure adjusting step, respective internal pressures in the plurality of cavities are measured after the joining step, a cavity among the plurality of cavities where a measured value about the internal pressure is beyond a predetermined range is set as a target cavity, and the internal pressure in the target cavity is adjusted by application of the light to the internal pressure adjusting member in the target cavity in such a manner that the internal pressure in the target cavity falls within the predetermined range.

A fourth aspect of a method of manufacturing a device according to the present invention is a method of manufacturing a device including a plurality of cavities and comprises a joining step and an internal pressure adjusting step. In the joining step, two joining targets are joined to each other, thereby forming the plurality of cavities, and with at least one cavity among the plurality of cavities set as a target cavity, sealing an internal pressure adjusting member in the target cavity. The internal pressure adjusting member allows an internal pressure in the target cavity to be adjusted by application of light. In this case, the internal pressure adjusting member to be sealed in units of the target cavity is at least one of a gas adsorber that allows gas in the target cavity to be adsorbed thereon by application of the light and a gas generator that allows gas to be generated into the target cavity by application of the light. In the internal pressure adjusting step, the internal pressure in the target cavity is adjusted in units of the target cavity by application of the light to the internal pressure adjusting member in the target cavity after the joining step.

According to the third aspect or the fourth aspect of the manufacturing method described above, by setting the internal pressure adjusting member as an application target for the light (more specifically, a target for heating by application of the light), it becomes possible for gas in the cavity to be adsorbed on the gas adsorber to reduce the internal pressure in the cavity if the gas adsorber is sealed as the internal pressure adjusting member and also possible to generate gas from the gas generator into the cavity to increase the internal pressure in the cavity if the gas generator is sealed as the internal pressure adjusting member without heating an element (such as a sensor) sealed in the cavity. In other words, even if the element (such as a sensor) sealed in each cavity is an element to influence the internal pressure in the cavity (in terms of generation of gas, for example) by being heated, the third aspect of the manufacturing method described above can still prevent heating of the element (such as a sensor) sealed in each cavity, thereby allowing the internal pressure in the cavity to be adjusting using only the internal pressure adjusting member (if both the gas adsorber and the gas generator are sealed as the internal pressure adjusting member, using the gas adsorber and the gas generator selectively) without causing an influence from the element. Thus, it is possible to adjust the internal pressure in the cavity efficiently in a short time. Furthermore, by adjusting a condition for applying the light to the internal pressure adjusting member in units of the cavity, it becomes possible to control the internal pressure in each cavity with high accuracy.

In the third aspect of the manufacturing method described above, with only the cavity among the plurality of cavities where the measured value about the internal pressure is beyond the predetermined range set as a target (target cavity), the internal pressure can be adjusted in such a manner as to fall within the predetermined range by application of the light to the internal pressure adjusting member. More specifically, in units of the target cavity, an application condition is determined for allowing the internal pressure to be changed from the measured value to fall within the predetermined range, and the light can be applied to the internal pressure adjusting member under the determined application condition. This allows internal pressures in all the cavities to be controlled within the predetermined range. Thus, non-uniformity between devices in terms of the internal pressure in the cavity can be reduced, making it possible to reduce non-uniformity in device performance.

In the fourth aspect of the manufacturing method described above, with at least one cavity among the plurality of cavities set as a target (target cavity), the internal pressure can be adjusted in units of the target cavity. More specifically, in units of the target cavity, a condition for applying the light is determined to make a change to an internal pressure suitable for an element (such as a sensor) sealed in the target cavity, and the light can be applied to the internal pressure adjusting member under the determined application condition. Thus, it is possible to seal different elements in the separate cavities (including the target cavity) in one device, and to make an adjustment in units of the cavity to an internal pressure suitable for the element sealed in this cavity. As a result, the elements of different types to provide performance influenced by internal pressures can be mounted on one device.

A first aspect of a device according to the present invention comprises a cavity composed of two joining targets, and a gas generator sealed in the cavity. The gas generator allows gas to be generated into the cavity by application of light.

In the first aspect of the device described above, the device may further comprise a gas adsorber sealed in the cavity. The gas adsorber allows gas in the cavity to be adsorbed thereon by application of the light.

A second aspect of a device according to the present invention comprises a plurality of cavities composed of two joining targets, and an internal pressure adjusting member. With at least one cavity among the plurality of cavities set as a target cavity, the internal pressure adjusting member is sealed in the target cavity and allows an internal pressure in the target cavity to be adjusted by application of light. More specifically, the internal pressure adjusting member includes at least one of a gas adsorber and a gas generator provided in units of the target cavity. The gas adsorber allows gas in the target cavity to be adsorbed thereon by application of the light. The gas generator allows gas to be generated into the target cavity by application of the light.

In the first aspect or the second aspect of the device described above, the device may further comprise at least a part of an internal pressure measuring circuit for measuring an internal pressure in the cavity.

### Advantageous Effects of Invention

According to the present invention, in a device including a cavity, it is possible to control an internal pressure in the cavity efficiently with high accuracy.

### Brief Description of Drawings

FIG. 1A is a sectional view conceptually showing an example of a device manufactured by a manufacturing method according to a first embodiment, and FIG. 1B is a plan view showing the device without a lid part.
FIG. 2 is a conceptual view showing the manufacturing method according to the first embodiment in order in which processes are performed.
FIG. 3A is a sectional view conceptually showing an example of a device manufactured by a manufacturing method according to a second embodiment, and FIG. 3B is a plan view showing the device without a lid part.
FIG. 4 is a conceptual view showing the manufacturing method according to the second embodiment in order in which processes are performed.
FIG. 5A is a sectional view conceptually showing an example of a device manufactured by a manufacturing method according to a first modification, and FIG. 5B is a plan view showing the device without a lid part.
FIG. 6 is a conceptual view showing the manufacturing method according to the first modification in order in which processes are performed.
FIG. 7A is a sectional view conceptually showing an example of a device manufactured by a manufacturing method according to a third modification, and FIG. 7B is a plan view showing the device without a lid part.
FIG. 8 is a conceptual view showing the manufacturing method according to the third modification in order in which processes are performed.

### Description of Embodiments

### [1] First Embodiment

### [1-1] Device Configuration

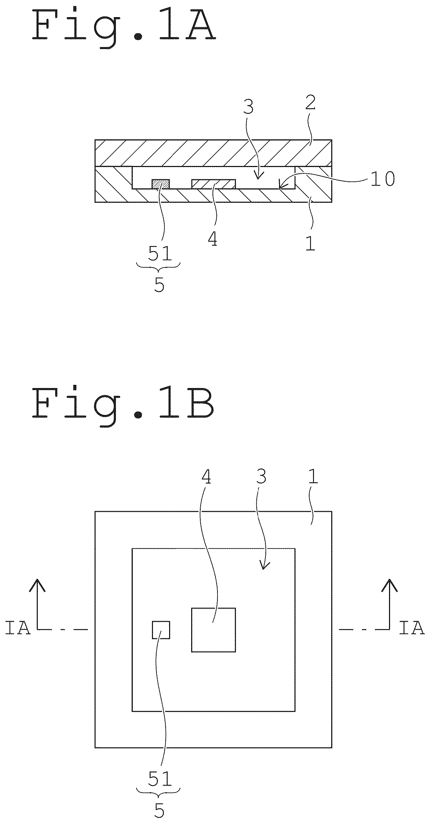

FIG. 1A is a sectional view conceptually showing an example of a device manufactured by a manufacturing method according to a first embodiment. The device includes a base part 1, a lid part 2, a cavity 3, an element 4, and an internal pressure adjusting member 5. FIG. 1B is a plan view showing the device without the lid part 2. FIG. 1A is a sectional view along a line IA-IA in FIG. 1B.

The base part 1 and the lid part 2 are composed of base materials such as substrates, and are joined to each other. More specifically, a recess 10 to become the cavity 3 is provided at the base part 1, and the lid part 2 is joined to the base part 1 in a state of closing the recess 10. As a result, the cavity 3 is formed as internal space sealed by the base part 1 and the lid part 2.

The element 4 is sealed in the cavity 3. Here, the element 4 is a part to fulfill at least one of functions of the device, and is a sensor (such as an acceleration sensor or a gyroscope sensor), a micromachine (such as an actuator), or an electronic circuit, for example.

Depending on the type of the element 4 to be sealed in the cavity 3, it is important, in some cases, that an internal pressure in the cavity 3 be at an appropriate value in terms of enhancing the performance of the element 4. As an example, if the element 4 is an acceleration sensor, the internal pressure in the cavity 3 is preferably at a moderately low value in order to allow the acceleration sensor to be damped by air resistance. As another example, if the element 4 is a gyroscope sensor, the internal pressure in the cavity 3 is preferably as low as possible (in other words, a degree of vacuum is preferably as high as possible).

In order to allow the internal pressure in the cavity 3 to be controlled efficiently with high accuracy, the internal pressure adjusting member 5 is further sealed in the cavity 3. Here, the internal pressure adjusting member 5 is a member for allowing the internal pressure in the cavity 3 to be adjusted by application of light such as laser light or light from a flash lamp. In the present embodiment, a gas adsorber 51 that allows gas to be adsorbed thereon by application of the light is sealed as the internal pressure adjusting member 5 in the cavity 3. The following describes a method of manufacturing the device in detail using the described internal pressure adjusting member 5.

### [1-2] Method of Manufacturing Device

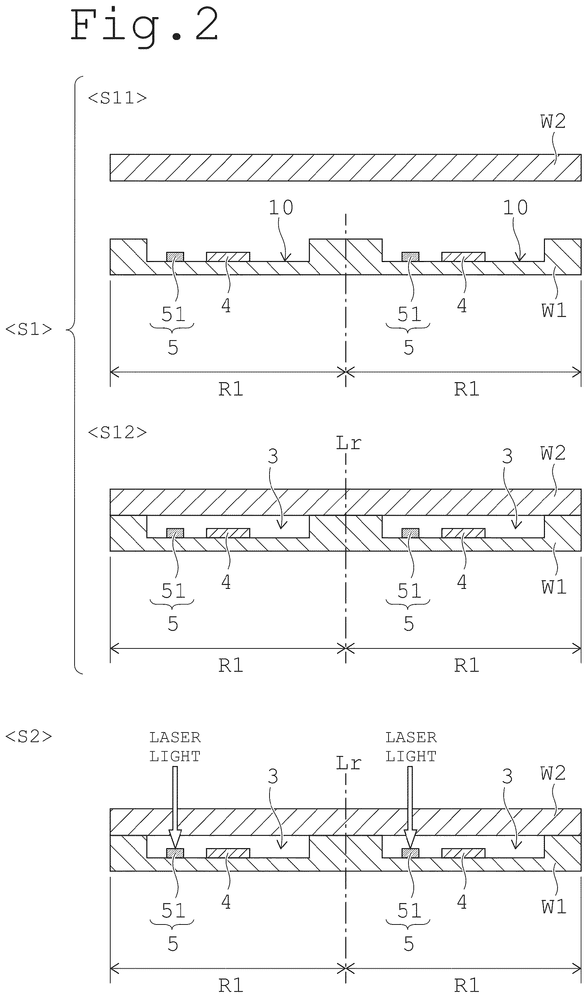

FIG. 2 is a conceptual view showing the manufacturing method according to the first embodiment in order in which processes are performed. The manufacturing method shown as an example in FIG. 2 is to manufacture a plurality of devices together. This manufacturing method includes a joining step S1, an internal pressure adjusting step S2, and a cutting step S3 performed in this order. Each of the steps will be described below in detail. This manufacturing method is further applicable to a case where only one device is to be manufactured. In this case, the cutting step S3 is omissible.

### <Joining Step S1>

In the joining step S1, two joining targets W1 and W2 are joined to each other. Here, the joining target W1 is composed of a base material such as a substrate, and includes a plurality of regions R1 to become the base parts 1 by being singulated individually by cutting. The recess 10 to become the cavity 3 is provided in each region R1. The joining target W2 is composed of a base material such as a substrate. By the cutting of the joining target W1, the joining target W2 is singulated individually together with the joining target W1 to become the lid part 2.

As a specific configuration, in the joining step S1, the element 4 is first mounted at a predetermined position in the recess 10 in each region R1 (a position where the element 4 is to be connected properly to an electronic circuit formed in this region R1, for example) (step S11). The internal pressure adjusting member 5 (in the present embodiment, the gas adsorber 51) is further mounted at a position in the recess 10 in each region R1 differing from the mounting position of the element 4 (the above-described predetermined position).

Then, the two joining targets W1 and W2 are joined to each other to close all the recesses 10 with the joining target W2. By doing so, in each region R1, the cavity 3 is formed and the element 4 and the internal pressure adjusting member 5 are sealed in this cavity 3 (step S12).

### <Internal Pressure Adjusting Step S2>

In the internal pressure adjusting step S2, an internal pressure in each cavity 3 is adjusted by applying light to the internal pressure adjusting member 5 (in the present embodiment, the gas adsorber 51) in this cavity 3. More specifically, laser light is applied to the gas adsorber 51 in each cavity 3 to heat the gas adsorber 51. This adsorbs gas on the gas adsorber 51 in each cavity 3, thereby reducing the internal pressure in each cavity 3. In doing this, the amount of the gas to be adsorbed on the gas adsorber 51 can be controlled by adjusting a condition for applying the laser light (such as output, a duration of application, a range of application on the gas adsorber 51, etc.) as appropriate. This makes it possible to adjust the internal pressure in the cavity 3.

By setting the gas adsorber 51 as an application target for the laser light (more specifically, a target for heating by application of the laser light) in this way, it becomes possible for gas in each cavity 3 to be adsorbed on the gas adsorber 51 to reduce the internal pressure in this cavity 3 without heating the element 4 (such as a sensor) sealed in the cavity 3. In other words, even if the element 4 (such as a sensor) sealed in each cavity 3 is an element to influence the internal pressure in this cavity 3 (in terms of generation or adsorption of gas, for example) by being heated, the processes described above can still prevent heating of the element 4 (such as a sensor) sealed in each cavity 3, thereby allowing the internal pressure in the cavity 3 to be reduced using only the gas adsorber 51 without causing an influence from this element 4. Thus, it is possible to reduce the internal pressure in the cavity 3 efficiently in a short time. Furthermore, by adjusting a condition for applying the laser light to the gas adsorber 51 (such as output, a duration of application, a range of application on the gas adsorber 51, etc.), it becomes possible to control the internal pressure in the cavity 3 with high accuracy.

In the internal pressure adjusting step S2, light from a flash lamp (a surface-emitting flash lamp, for example) may be applied to the gas adsorber 51 instead of laser light. In this case, by using a mask allowing the light from the flash lamp to be blocked selectively, it becomes possible to extract only light to be applied to the gas adsorber 51.

### <Cutting Step S3>

In the cutting step S3, the two joining targets W1 and W2 are subjected to cutting, thereby singulating the regions R1 individually in the joining target W1 (not shown in the drawings). More specifically, the two joining targets W1 and W2 are cut along a boundary line Lr for partitioning between the regions R1 (see the internal pressure adjusting step S2 in FIG. 2), thereby singulating these regions R1 individually. As a method of this cutting, a method such as a blade dicing method, a plasma etching method, or a laser ablation method may be used. As a result, the device with the element 4 sealed in the cavity 3 is manufactured. In the device obtained in the present embodiment, the internal pressure in the cavity 3 is controlled with high accuracy at a value suitable for the element 4.

### [2] Second Embodiment

In a case described in a second embodiment, instead of the gas adsorber 51, a gas generator 52 is used as the internal pressure adjusting member 5 that allows gas to be generated by application of light such as laser light or light from a flash lamp.

### [2-1] Device Configuration

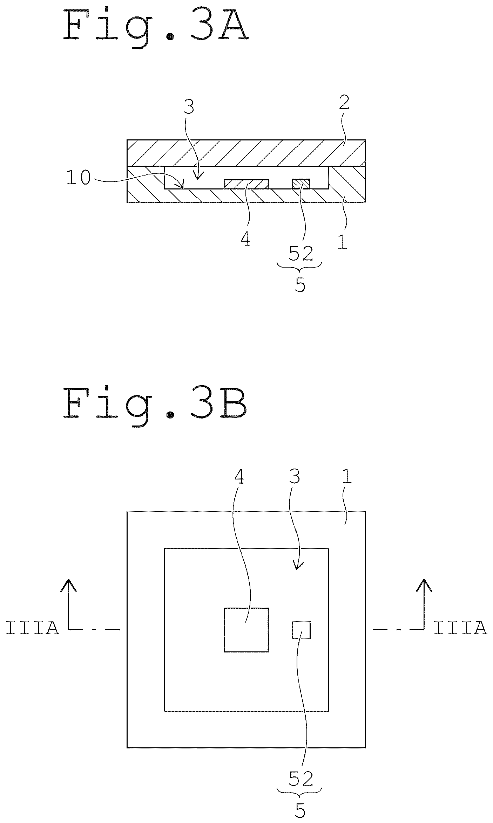

FIG. 3A is a sectional view conceptually showing an example of a device manufactured by a manufacturing method according to the second embodiment. FIG. 3B is a plan view showing the device without the lid part 2. FIG. 3A is a sectional view along a line IIIA-IIIA in FIG. 3B. In the second embodiment, the device includes the gas generator 52 instead of the gas adsorber 51. The other configuration of the device is the same as that of the first embodiment, so that description thereof will be omitted.

### [2-2] Method of Manufacturing Device

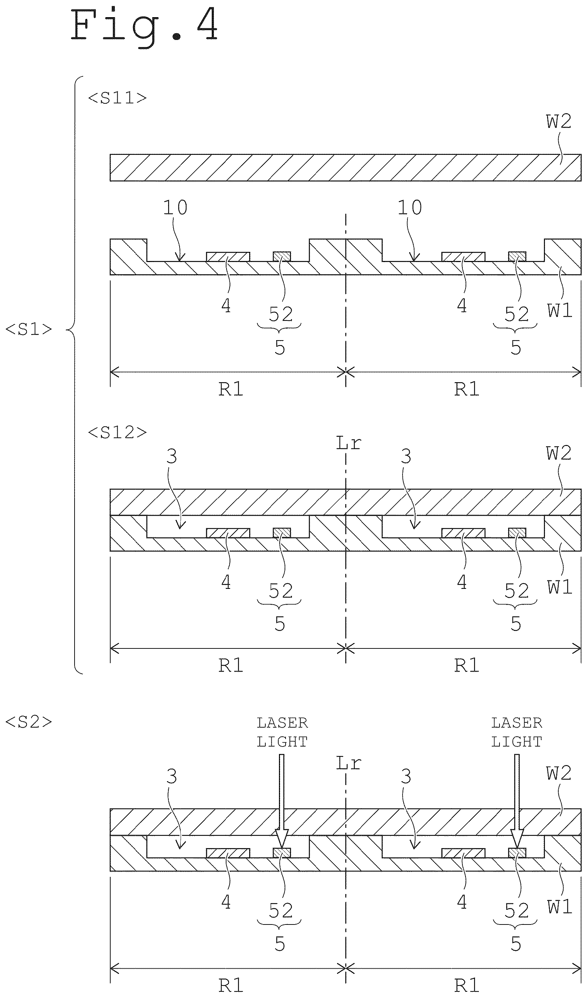

FIG. 4 is a conceptual view showing the manufacturing method according to the second embodiment in order in which processes are performed. In the following, a configuration differing from that of the first embodiment will be described in detail.

### <Joining Step S1>

In the joining step S1, the gas generator 52 is mounted in the recess 10 in each region R1 (step S11). More specifically, the gas generator 52 is mounted at a position in the recess 10 in each region R1 differing from the mounting position of the element 4 (predetermined position). Then, the two joining targets W1 and W2 are joined to each other to close all the recesses 10 with the joining target W2. By doing so, in each region R1, the cavity 3 is formed and the element 4 and the gas generator 52 are sealed in this cavity 3 (step S12).

### <Internal Pressure Adjusting Step S2>

In the internal pressure adjusting step S2, an internal pressure in each cavity 3 is adjusted by applying light to the gas generator 52 in this cavity 3. More specifically, laser light is applied to the gas generator 52 in each cavity 3 to heat the gas generator 52. This generates gas from the gas generator 52 in each cavity 3, thereby increasing the internal pressure in each cavity 3. In doing this, the amount of the gas to be generated from the gas generator 52 can be controlled by adjusting a condition for applying the laser light (such as output, a duration of application, a range of application on the gas generator 52, etc.) as appropriate. This makes it possible to adjust the internal pressure in the cavity 3.

By setting the gas generator 52 as an application target for the laser light (more specifically, a target for heating by application of the laser light) in this way, it becomes possible to generate gas from the gas generator 52 into each cavity 3 to increase the internal pressure in this cavity 3 without heating the element 4 (such as a sensor) sealed in the cavity 3. In other words, even if the element 4 (such as a sensor) sealed in each cavity 3 is an element to influence the internal pressure in this cavity 3 (in terms of generation or adsorption of gas, for example) by being heated, the processes described above can still prevent heating of the element 4 (such as a sensor) sealed in each cavity 3, thereby allowing the internal pressure in the cavity 3 to be increased using only the gas generator 52 without causing an influence from this element 4. Thus, it is possible to increase the internal pressure in the cavity 3 efficiently in a short time. Furthermore, by adjusting a condition for applying the laser light to the gas generator 52 (such as output, a duration of application, a range of application on the gas generator 52, etc.), it becomes possible to control the internal pressure in the cavity 3 with high accuracy. As a result, it is possible to manufacture the device where the internal pressure in the cavity 3 is controlled with high accuracy at a value suitable for the element 4.

In the internal pressure adjusting step S2, light from a flash lamp (a surface-emitting flash lamp, for example) may be applied to the gas generator 52 instead of laser light. In this case, by using a mask allowing the light from the flash lamp to be blocked selectively, it becomes possible to extract only light to be applied to the gas generator 52.

### [3] Modifications

### [3-1] First Modification

The manufacturing methods according to the first embodiment and the second embodiment described above can be changed, as appropriate, to a manufacturing method resulting from a combination thereof. This will be described below in detail.

### [3-1-1] Configuration of Device

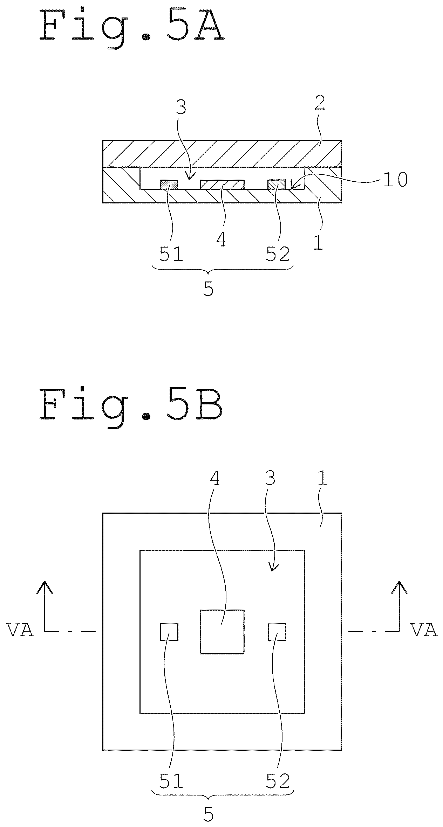

FIG. 5A is a sectional view conceptually showing an example of a device manufactured by a manufacturing method according to a first modification. FIG. 5B is a plan view showing the device without the lid part 2. FIG. 5A is a sectional view along a line VA-VA in FIG. 5B. In the first modification, the device includes both the gas adsorber 51 and the gas generator 52 as the internal pressure adjusting member 5. The other configuration of the device is the same as that of the first embodiment, so that description thereof will be omitted.

### [3-1-2] Method of Manufacturing Device

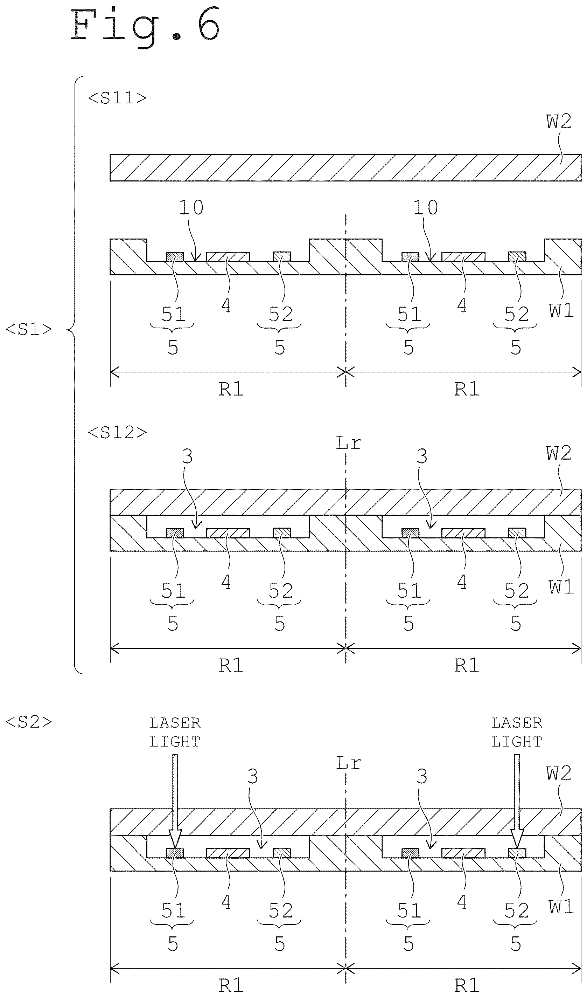

FIG. 6 is a conceptual view showing the manufacturing method according to the first modification in order in which processes are performed. In the following, a configuration differing from that of the first embodiment or the second embodiment will be described in detail.

### <Joining Step S1>

In the joining step S1, both the gas adsorber 51 and the gas generator 52 are mounted in the recess 10 in each region R1 (step S11). More specifically, the gas adsorber 51 and the gas generator 52 are mounted at respective positions in the recess 10 in each region R1 differing from the mounting position of the element 4 (predetermined position). Then, the two joining targets W1 and W2 are joined to each other to close all the recesses 10 with the joining target W2. By doing so, in each region R1, the cavity 3 is formed and the element 4 and the internal pressure adjusting member 5 (here, both the gas adsorber 51 and the gas generator 52) are sealed in this cavity 3 (step S12).

### <Internal Pressure Adjusting Step S2>

In the internal pressure adjusting step S2, an internal pressure in each cavity 3 is adjusted by applying light to the internal pressure adjusting member 5 in this cavity 3. More specifically, light (such as laser light or light from a flash lamp) is applied to at least one of the gas adsorber 51 and the gas generator 52 in each cavity 3 to heat the application target for the light. By doing so, if the application target for the light is the gas adsorber 51, gas is adsorbed on the gas adsorber 51 in each cavity 3 to reduce the internal pressure in this cavity 3. If the application target for the light is the gas generator 52, gas is generated from the gas generator 52 in each cavity 3 to increase the internal pressure in this cavity 3. In doing this, the amount of the gas to be adsorbed on the gas adsorber 51 and the amount of the gas to be generated from the gas generator 52 can be controlled selectively by adjusting a selection of the application target and a condition for applying the light to the selected application target (such as output, a duration of application, a range of application on the application target, etc.) as appropriate. This makes it possible to adjust the internal pressure in the cavity 3.

By setting the gas adsorber 51 and the gas generator 52 as application targets for light (more specifically, targets for heating by application of the light) and applying the light selectively to the application targets in this way, it becomes possible for gas in each cavity 3 to be adsorbed on the gas adsorber 51 to reduce the internal pressure in the cavity 3 and also possible to generate gas from the gas generator 52 into the cavity 3 to increase the internal pressure in the cavity 3 without heating the element 4 (such as a sensor) sealed in the cavity 3. In other words, it is possible to adjust the internal pressure in the cavity 3 by using the gas adsorber 51 and the gas generator 52 selectively without causing an influence from the element 4 (such as a sensor) sealed in the cavity 3. This allows the internal pressure in the cavity 3 to be adjusted efficiently in a short time. Furthermore, by adjusting a condition for applying the light to each of the gas adsorber 51 and the gas generator 52 (such as output, a duration of application, a range of application on the application target, etc.), it becomes possible to control the internal pressure in the cavity 3 with high accuracy.

### [3-2] Second Modification

In any of the above-described manufacturing methods, to manufacture a plurality of devices together, an internal pressure in each cavity 3 may be measured and light may be applied on the basis of a measured value about the internal pressure in such a manner that the internal pressure falls within a predetermined range in the internal pressure adjusting step S2. In this case, the joining target W1 or W2 to be used is prepared by providing a base material such as a substrate with an internal pressure measuring circuit (including a sensor, an interconnect line, etc.) for measuring the internal pressure in each cavity 3.

The internal pressure measuring circuit remains in each device to be manufactured. As a specific example, if the manufacturing method includes the cutting step S3, the internal pressure measuring circuit is cut together with the joining targets W1 and W2 to be left partially in each device. In this case, the internal pressure measuring circuit is not limited to a circuit to become completely non-functional as a circuit in each device after implementation of the cutting step S3 but may be provided in such a manner as to become functional as an internal pressure measuring circuit in each device even after implementation of the cutting step S3. As another specific example, if the manufacturing method does not include the cutting step S3, the internal pressure measuring circuit is left as it is in the device. The internal pressure measuring circuit may be provided in such a manner as to become totally separable and removable from each device by the cutting in the cutting step S3.

According to the above-described second modification, it is possible to adjust the internal pressure in the cavity 3 with high accuracy to a value suitable for the element 4 sealed in this cavity 3. In doing this, internal pressures in all the cavities 3 may be adjusted uniformly under the same application condition or may be adjusted individually under application conditions suitable for respective cavities 3, as will be described below.

More specifically, in the internal pressure adjusting step S2, respective internal pressures in a plurality of the cavities 3 may be measured, and a cavity 3 among these cavities 3 where a measured value about the internal pressure is beyond a predetermined range may be set as a target cavity 3t. Then, the internal pressure in the target cavity 3t may be adjusted individually to fall within the predetermined range by applying light only to the internal pressure adjusting member 5 in the target cavity 3t (if both the gas adsorber 51 and the gas generator 52 are sealed as the internal pressure adjusting member 5, by applying light selectively to the gas adsorber 51 and the gas generator 52, namely, by using the gas adsorber 51 and the gas generator 52 selectively). Still more specifically, in units of the target cavity 3t, an application condition may be determined for allowing the internal pressure to be changed from the measured value to fall within the predetermined range, and light can be applied to the internal pressure adjusting member 5 under the determined application condition.

This allows the internal pressures in all the cavities 3 to be controlled within the predetermined range. Thus, non-uniformity between the devices in terms of the internal pressure in the cavity 3 can be reduced, making it possible to reduce non-uniformity in device performance.

By applying the above-described method of the second modification (the method using the measured value about the internal pressure) to the first modification, it becomes possible to control the internal pressure in the cavity 3 easily within the predetermined range. More specifically, if the measured value about the internal pressure is higher than an upper limit of the predetermined range, reducing the internal pressure in the cavity 3 by application of light to the gas adsorber 51 might result in a situation where the internal pressure in the cavity 3 goes beyond the predetermined range to become lower than a lower limit thereof. Even on the occurrence of such a situation, according to the first modification, the internal pressure can still be adjusted again so as to fall within the predetermined range by selecting the gas generator 52 instead of the gas adsorber 51 as an application target for light. If the measured value about the internal pressure is lower than the lower limit of the predetermined range, increasing the internal pressure in the cavity 3 by application of light to the gas generator 52 might result in a situation where the internal pressure in the cavity 3 goes beyond the predetermined range to become higher than the upper limit thereof. Even on the occurrence of such a situation, according to the first modification, the internal pressure can still be adjusted again so as to fall within the predetermined range by selecting the gas adsorber 51 instead of the gas generator 52 as an application target for light.

### [3-3] Third Modification

### [3-3-1] Configuration of Device

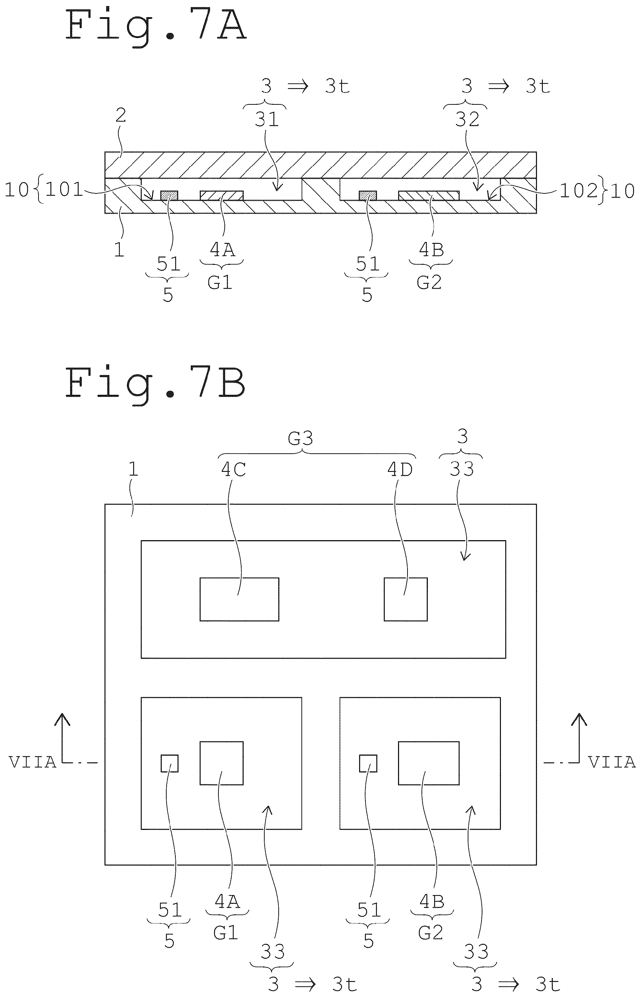

FIG. 7A is a sectional view conceptually showing an example of a device manufactured by a manufacturing method according to a third modification. FIG. 7B is a plan view showing the device without the lid part 2. FIG. 7A is a sectional view along a line VIIA-VIIA in FIG. 7B.

In the third modification, the device includes a plurality of the cavities 3. More specifically, the device includes the cavities 3 that are sealed independently of each other by the joining between the base part 1 and the lid part 2. One or two or more elements 4 are sealed in each cavity 3. In the present modification, division is made between a plurality of the elements 4 to be mounted on the device into several groups in response to internal pressures required by the elements 4. As an example, some of the elements 4 overlapping each other in terms of their permissible ranges for required internal pressures are gathered in one group, thereby allowing the plurality of elements 4 to be divided into the several groups. The cavities 3 are provided in one-to-one correspondence with these groups. In other words, the cavity 3 is provided in response to each group in such a manner as to allow an adjustment to an internal pressure suitable for the element 4 in units of the group.

In the example in FIG. 7B, the device includes four elements 4A to 4D. As specific examples, the element 4A is an acceleration sensor, the element 4B is a gyroscope sensor, the element 4C is an LSI, and the element 4D is a pressure sensor. Here, the acceleration sensor can provide high performance if an internal pressure is at a moderately low value. The gyroscope sensor can provide high performance if an internal pressure is at a value as low as possible. On the other hand, each of the LSI and the pressure sensor can provide sufficiently high performance even if an internal pressure is left at an atmospheric pressure. Then, in the example in FIG. 7B, the element 4A is divided into a group G1, the element 4B is divided into a group G2, and the elements 4C and 4D are divided into a group G3, and three cavities 31 to 33 are provided in one-to-one correspondence with the groups G1 to G3 respectively.

In the present modification, at least one cavity 3 among a plurality of the cavities 3 is set as the target cavity 3t. Here, the target cavity 3t is the cavity 3 among the plurality of cavities 3 where an internal pressure is required to be adjusted (to be adjusted for enhancing the performance of the element 4 sealed therein). The internal pressure adjusting member 5 is further sealed in the target cavity 3t. More specifically, at least one of the gas adsorber 51 and the gas generator 52 is sealed as the internal pressure adjusting member 5 in the target cavity 3t. In the presence of a plurality of the target cavities 3t, in units of the target cavity 3t, at least one of the gas adsorber 51 and the gas generator 52 is sealed as the internal pressure adjusting member 5 in this target cavity 3t in response to an internal pressure required by the element 4 to be sealed in this target cavity 3t.

In the exemplary case shown in in FIG. 7B, only the gas adsorber 51 is sealed in each of the two cavities 31 and 32 where internal pressures are required to be adjusted.

### [3-2-2] Method of Manufacturing Device

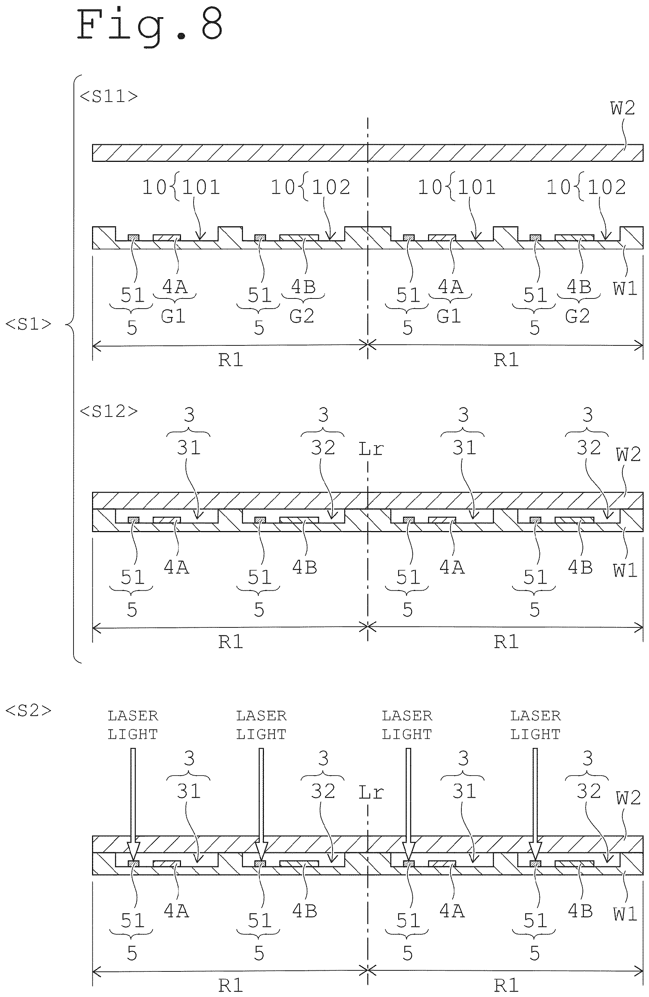

FIG. 8 is a conceptual view showing the manufacturing method according to the third modification in order in which processes are performed. The manufacturing method shown as an example in FIG. 8 is to manufacture a plurality of the devices together shown in FIGS. 7A and 7B. This manufacturing method includes the joining step S1, the internal pressure adjusting step S2, and the cutting step S3 performed in this order. Each of the steps will be described below in detail. This manufacturing method is further applicable to a case where only one device is to be manufactured. In this case, the cutting step S3 is omissible.

### <Joining Step S1>

In the joining step S1, the two joining targets W1 and W2 are joined to each other. Here, the joining target W1 is composed of a base material such as a substrate, and includes a plurality of the regions R1 to become the base parts 1 by being singulated individually by cutting. Three recesses 101 to 103 to become the cavities 31 to 33 respectively (the recess 103 does not appear in FIG. 8) are provided in each region R1. The joining target W2 is composed of a base material such as a substrate. By the cutting of the joining target W1, the joining target W2 is singulated individually together with the joining target W1 to become the lid part 2.

As a specific configuration, in the joining step S1, the elements 4 belonging to the groups G1 to G3 corresponding to the cavities 31 to 33 respectively are first mounted at respective predetermined positions (positions where the elements 4 are to be connected properly to electronic circuits formed in each region R1, for example) in the three recesses 101 to 103 to become the cavities 31 to 33 respectively in this region R1 (step S11). More specifically, the element 4A (acceleration sensor, for example) is mounted at a predetermined position in the recess 101, the element 4B (gyroscope sensor, for example) is mounted at a predetermined position in the recess 102, and the elements 4C and 4D (LSI and pressure sensor, for example) are mounted at two predetermined positions in the recess 103.

In step S11, in each of the recesses 10 (in the example in FIG. 8, the recesses 101 and 102) among the three recesses 101 to 103 provided in each region R1 and to become the target cavities 3t, the internal pressure adjusting member 5 is further mounted at a position differing from the mounting position of the element 4 (the above-described predetermined position) (in the example in FIG. 8, the gas adsorber 51 is mounted in each of the recesses 101 and 102).

Then, the two joining targets W1 and W2 are joined to each other to close all the recesses 10 with the joining target W2. By doing so, in each region R1, the three cavities 31 to 33 sealed independently of each other are formed, the elements 4 are sealed in the corresponding ones of the cavities 31 to 33, and the internal pressure adjusting members 5 are further sealed in the target cavities 3t (in the example in FIG. 8, the cavities 31 and 32) among the cavities 31 to 33 (step S12).

### <Internal Pressure Adjusting Step S2>

In the internal pressure adjusting step S2, an internal pressure is adjusted in units of the target cavity 3t by applying light to the internal pressure adjusting member 5 (in the example in FIG. 8, the gas adsorber 51) in this target cavity 3t. More specifically, laser light is applied to the gas adsorber 51 in each target cavity 3t to adjust the internal pressure. Here, the target cavities 3t (in the example in FIG. 8, the cavities 31 and 32) are sealed independently of each other and are also sealed independently of the other cavity 3. This allows the internal pressures in the target cavities 3t to be adjusted individually.

More specifically, a condition is determined in units of the target cavity 3t for applying the laser light (such as output, a duration of application, a range of application on the gas adsorber 51, etc.) to make a change to an internal pressure suitable for the element 4 (such as a sensor) sealed in this target cavity 3t, and the laser light can be applied to the gas adsorber 51 under the determined application condition. In other words, the amount of gas to be adsorbed on the gas adsorber 51 can be controlled in units of the target cavity 3t by adjusting a condition for applying the laser light in units of the target cavity 3t, as appropriate. This eventually makes it possible to adjust the internal pressure in units of the target cavity 3t. This allows the internal pressure in each target cavity 3t to be adjusted with high accuracy to an internal pressure suitable for the element 4 sealed in this target cavity 3t.

As described above, according to the manufacturing method of the present modification, it is possible to seal the different elements 4 in the separate cavities 3 (including the target cavity 3t) in one device, and to make an adjustment in units of the cavity 3 to an internal pressure suitable for the element 4 sealed in this cavity 3. Thus, the elements 4 of different types to provide performance influenced by internal pressures can be mounted on one device.

In the internal pressure adjusting step S2, light from a flash lamp (a surface-emitting flash lamp, for example) may be applied to the gas adsorber 51 instead of laser light. In this case, by using a mask allowing the light from the flash lamp to be blocked selectively, it becomes possible to extract only light to be applied to the gas adsorber 51.

### <Cutting Step S3>

In the cutting step S3, the two joining targets W1 and W2 are subjected to cutting, thereby singulating the regions R1 individually in the joining target W1 (not shown in the drawings). More specifically, the two joining targets W1 and W2 are cut along a boundary line Lr for partitioning between the regions R1 (see the internal pressure adjusting step S2 in FIG. 8), thereby singulating these regions R1 individually. As a method of this cutting, a method such as a blade dicing method, a plasma etching method, or a laser ablation method may be used. As a result, the device with the elements 4 sealed in the plurality of cavities 3 is manufactured. In the device obtained in the present modification, the internal pressure in each cavity 3 is controlled with high accuracy at a value suitable for the element 4.

The manufacturing method of the present modification described above is applicable not only to a case of manufacturing a device having the exemplary configuration shown in FIGS. 7A and 7B but also to a case of manufacturing devices having configurations changed in various ways (more specifically, devices changed in configurations in terms of the number of the cavities 3, the number of the target cavities 3t, and types of the elements 4 to be sealed in these cavities 3 (including a method of dividing these elements 4 into groups)).

The internal pressure adjusting member 5 to be sealed in each target cavity 3t is not limited to the gas adsorber 51. Like in the second embodiment, the gas generator 52 may be sealed instead of the gas adsorber 51 in response to an internal pressure required by the element 4 to be sealed in this target cavity 3t.

Like in the second modification, both the gas adsorber 51 and the gas generator 52 may be sealed in each target cavity 3t. This adjusts an internal pressure in each target cavity 3t easily with high accuracy to a value suitable for the element 4 sealed in this target cavity 3t.

### [3-4] Other Modifications

As long as light to be applied to the internal pressure adjusting member 5 is capable of passing through the joining target W1 or W2 and capable of heating the internal pressure adjusting member 5 by being applied to the internal pressure adjusting member 5, it can be changed, as appropriate, to light other than laser light or light from a flash lamp.

A material of the internal pressure adjusting member 5 and light to be applied to the internal pressure adjusting member 5 are not limited to those to cause adsorption or generation of gas by heating through application of light but can be changed, as appropriate, to those to allow adsorption or generation of gas without heating (such as those to generate a phenomenon like ablation, for example).

The above explanations of the embodiments and the modifications are nothing more than illustrative in any respect, nor should be thought of as restrictive. The scope of the present invention is indicated by claims rather than the above embodiments and modifications. Furthermore, it is intended that all changes that are equivalent to a claim in the sense and realm of the doctrine of equivalence be included within the scope of the present invention.

Some of the steps forming the methods of manufacturing the devices may be extracted partially as subjects of the invention or each of the steps may be extracted individually as a subject of the invention from the above embodiments and modifications. A subject determined by selectively combining the above embodiments and modifications may also be extracted as a subject of the invention.

### Reference Signs List

1 Base part
2 Lid part
3 Cavity
3t Target cavity
4 Element
4A, 4B, 4C, 4D Element
5 Internal pressure adjusting member
10 Recess
31, 32, 33 Cavity
51 Gas adsorber
52 Gas generator
G1, G2, G3 Group
Lr Boundary line
R1 Region
S1 Joining step
S2 Internal pressure adjusting step
S3 Cutting step
W1, W2 Joining target
101, 102, 103 Recess

## Claims

1. A method of manufacturing a device including a cavity, comprising:
a joining step that joins two joining targets to each other, thereby forming the cavity and sealing a gas adsorber in the cavity, the gas adsorber allowing gas in the cavity to be adsorbed thereon by application of light; and
an internal pressure adjusting step that adjusts an internal pressure in the cavity by application of the light to the gas adsorber after the joining step.

2. The method of manufacturing the device according to claim 1, wherein
in the joining step, a gas generator is further sealed in the cavity in addition to the gas adsorber, the gas generator allowing gas to be generated into the cavity by application of the light, and
in the internal pressure adjusting step, the internal pressure in the cavity is adjusted by application of the light to at least one of the gas adsorber and the gas generator.

3. A method of manufacturing a device that is a method of manufacturing a device including a cavity, comprising:
a joining step that joins two joining targets to each other, thereby forming the cavity and sealing a gas generator in the cavity, the gas generator allowing gas to be generated into the cavity by application of light; and
an internal pressure adjusting step that adjusts an internal pressure in the cavity by application of the light to the gas generator after the joining step.

4. The method of manufacturing the device according to any one of claims 1 to 3, wherein
in the internal pressure adjusting step, the internal pressure in the cavity is measured, and on the basis of a measured value about the internal pressure, the light is applied in such a manner that the internal pressure falls within a predetermined range.

5. A method of manufacturing a plurality of devices each including a cavity, comprising:
a joining step that joins two joining targets to each other, thereby forming a plurality of the cavities and sealing an internal pressure adjusting member in each of the cavities, the internal pressure adjusting member allowing an internal pressure in the cavity to be adjusted by application of light, the internal pressure adjusting member to be sealed in units of the cavity being at least one of a gas adsorber that allows gas in the cavity to be adsorbed thereon by application of the light and a gas generator that allows gas to be generated into the cavity by application of the light; and
an internal pressure adjusting step that measures respective internal pressures in the plurality of cavities after the joining step, sets a cavity among the plurality of cavities where a measured value about the internal pressure is beyond a predetermined range as a target cavity, and adjusts the internal pressure in the target cavity by application of the light to the internal pressure adjusting member in the target cavity in such a manner that the internal pressure in the target cavity falls within the predetermined range.

6. A method of manufacturing a device that is a method of manufacturing a device including a plurality of cavities, comprising:
a joining step that joins two joining targets to each other, thereby forming the plurality of cavities, and with at least one cavity among the plurality of cavities set as a target cavity, sealing an internal pressure adjusting member in the target cavity, the internal pressure adjusting member allowing an internal pressure in the target cavity to be adjusted by application of light, the internal pressure adjusting member to be sealed in units of the target cavity being at least one of a gas adsorber that allows gas in the target cavity to be adsorbed thereon by application of the light and a gas generator that allows gas to be generated into the target cavity by application of the light; and
an internal pressure adjusting step that adjusts the internal pressure in the target cavity in units of the target cavity by application of the light to the internal pressure adjusting member in the target cavity after the joining step.

7. A device comprising:
a cavity composed of two joining targets; and
a gas generator sealed in the cavity and allowing gas to be generated into the cavity by application of light.

8. The device according to claim 7, further comprising:
a gas adsorber sealed in the cavity and allowing gas in the cavity to be adsorbed thereon by application of the light.

9. A device comprising:
a plurality of cavities composed of two joining targets; and
an internal pressure adjusting member, with at least one cavity among the plurality of cavities set as a target cavity, the internal pressure adjusting member being sealed in the target cavity and allowing an internal pressure in the target cavity to be adjusted by application of light, wherein
the internal pressure adjusting member includes at least one of a gas adsorber and a gas generator provided in units of the target cavity, the gas adsorber allowing gas in the target cavity to be adsorbed thereon by application of the light, the gas generator allowing gas to be generated into the target cavity by application of the light.

10. The device according to any one of claims 7 to 9, further comprising:
at least a part of an internal pressure measuring circuit for measuring an internal pressure in the cavity.
